# EUROPEAN PATENT APPLICATION

(11) **EP 2 640 169 A2**
(43) Date of publication of application: **18.09.2013**
(21) Application number: 13153027.1
(22) Date of filing: 29.01.2013
(51) Int. Cl.: H05K 1/02, H05K 1/11

(54) **Multilayered wiring substrate and electronic apparatus**

(30) Priority: 21.02.2012 JP 2012035358
(71) Applicant: FUJITSU LIMITED, Kawasaki-shi, Kanagawa 211-8588 (JP)
(72) Inventor: Kawai, Kenichi, Kanagawa 211-8588 (JP)
(74) Representative: HOFFMANN EITLE

(57) **Abstract**

A multilayered wiring substrate (1) that includes at least one signal layer (3) and at least one ground layer (2) is provided. The multilayered wiring substrate includes a first signal via (12A) that extends in a direction substantially perpendicular to the layers of the multilayered wiring substrate, is conductively connected to one of a pair of differential signaling wires (30A) provided in the signal layer, and is formed on a first grid point; and a second signal via (12B) that extends in a direction substantially perpendicular to the layers of the multilayered wiring substrate, is conductively connected to the other of the pair of differential signaling wires (30A), and is formed on a second grid point that is positioned diagonally adjacent with respect to the first signal via.

## Description

### FIELD

The embodiments discussed herein are related to a multilayered wiring substrate and an electronic apparatus.

### BACKGROUND

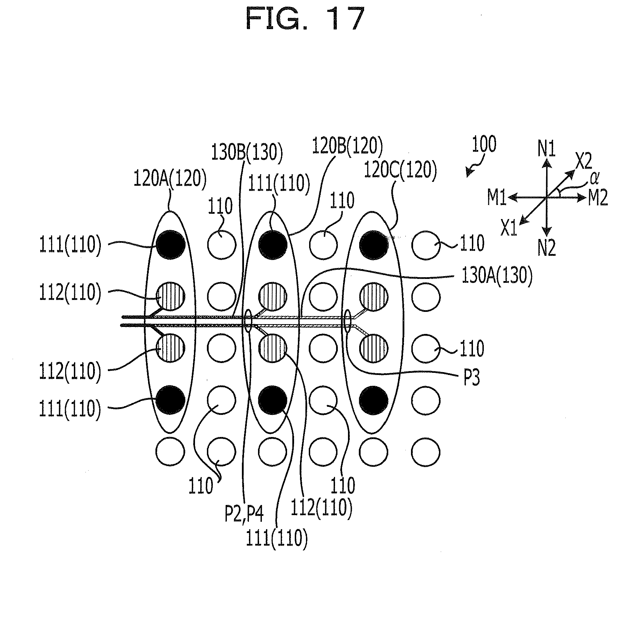

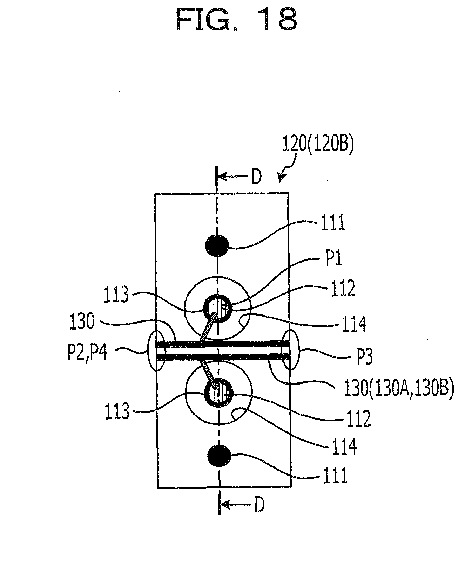

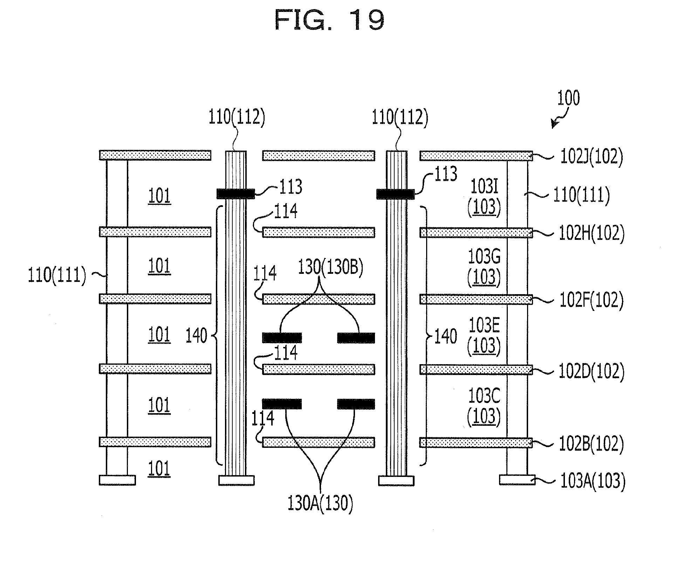

There is a technology that connects each layer within a multilayered wiring substrate using a via. FIG. 17 is an explanatory view illustrating an example of an arrangement relationship of signal via pairs in a multilayered wiring substrate of which a portion is omitted, FIG. 18 is an explanatory view illustrating an example of a signal via pair, and FIG. 19 is a cross-sectional view taken along line D-D of FIG. 18, of which a portion is omitted.

A multilayered wiring substrate 100 illustrated in FIG. 19 has a multilayered structure in which a plurality of ground layers 102 and a plurality of signal layers 103 are sequentially layered with an insulation material 101. For example, in the multilayered wiring substrate 100, a second ground layer 102B, a third signal layer 103C, a fourth ground layer 102D, a fifth signal layer 103E, a sixth ground layer 102F and a seventh signal layer 103G are sequentially layered in this order on a first signal layer 103A. Additionally, in the multilayered wiring substrate 100, an eighth ground layer 102H, a ninth signal layer 103I, and a tenth ground layer 102J are sequentially layered in this order on the seventh signal layer 103G.

A plurality of vias 110 are formed in a grid pattern on a layered surface of the multilayered wiring substrate 100 with a given pitch, and each via 110 is formed by filling a hole extending in a direction perpendicular to the layered surface with a conductive material such as, for example, copper. Each via 110 is connected to each the layer within the multilayered wiring substrate 100.

The plurality of vias 110 include ground vias 111 and differential signaling vias 112. A ground via 111 is connected to a ground layer 102. A differential signaling via 112 is connected with a signal layer 103 through a signal area 113. For the convenience of description, in FIG. 17 a ground via 111 is represented by a black circle and a differential signaling via 112 is represented by a hatched circle.

A signal via pair 120 includes, for example, a pair of differential signaling vias 112 adjacent to each other along the N1-N2 axis, and a pair of ground vias 111 with the pair of differential signaling vias 112 interposed therebetween. The signal via pair 120 is connected to, for example, a ball grid array (BGA) or a land grid array (LGA). Each signal via pair 120 is disposed to be offset from an adjacent signal via pair 120 by, for example, one or two via portions.

A clearance 114 that prevents an electrical short between the pair of differential signaling vias 112 and has a diameter larger than that of the differential signaling via 112, is formed in each ground layer 102 through which a differential signaling via 112 disposed within the signal via pair 120 is inserted through. The clearance 114 is formed at a position that does not contact with the differential signaling via 112.

In the multilayered wiring substrate 100, when wiring is led out from a differential signaling via 112 of the signal via pair 120, a differential pair 130 is disposed along a direction in which the wiring is led out, and the wiring is led out from the differential signaling via 112 using the differential pair 130.

The multilayered wiring substrate 100 as illustrated in FIG. 17 includes, for example, a first signal via pair 120A, a second signal via pair 120B, and a third signal via pair 120C. The multilayered wiring substrate 100 includes a first differential pair 130A configured to lead out the wiring from the differential signaling vias 112 of the third signal via pair 120C and a second differential pair 130B configured to lead out the wiring from the differential signaling vias 112 of a second signal via pair 120B. As illustrated in FIG. 19, the first differential pair 130A is disposed in the third signal layer 103C between the second ground layer 102B and the fourth ground layer 102D, and passes, for example, between the differential signaling vias 112 that are within the first signal via pair 120A. The second differential pair 130B is disposed in the fifth signal layer 103E between the fourth ground layer 102D and the sixth ground layer 102F, and passes, for example, between the differential signaling vias 112 that are within the first signal via pair 120A.

However, with the recent demand for wiring densification, because the distance between the pair of differential signaling vias 112 within a signal via pair 120 becomes short in the multilayered wiring substrate 100, the influence of electromagnetic waves that are generated between the differential signaling vias 112 increases. Furthermore, when the differential pair 130 passes between the pair of differential signaling vias 112, crosstalk increases due to the interference of electromagnetic waves between the differential signaling vias 112 and the differential pair 130. As a result, the signal of the differential signaling vias 112 becomes noise to the signal of the differential pair 130, and the signal of the differential pair 130 becomes noise to the signal of the differential signaling vias 112.

In addition, in the multilayered wiring substrate 100, electromagnetic waves that leaks from a stub 140 of a differential signaling via 112 affect an adjacent differential pair 130. As described above, the signal of differential signaling vias 112 and the signal of the differential pair 130 become noise to each other, and electromagnetic waves leak from the stub 140 of a differential signaling via 112, so that crosstalk between differential signaling vias 112 and the differential pair 130 increases.

The followings are reference documents.
[Document 1] Japanese Laid-open Patent Publication No. 60-127797
[Document 2] Japanese National Publication of International Patent Application No. 2010-506380
[Document 3] Japanese Laid-open Patent Publication No. 2011-18673
[Document 4] Japanese Laid-open Patent Publication No. 8-204338
[Document 5] Japanese Laid-open Patent Publication No. 2001-119154
[Document 6] Japanese Laid-open Patent Publication No. 2004-95614

### SUMMARY

According to an aspect of the embodiments, a multilayered wiring substrate includes at least one signal layer and at least one ground layer. The multilayered wiring substrate includes: a first signal via extending in a direction substantially perpendicular to the layers of the multilayered wiring substrate, the first signal via being connected to one of a pair of differential signaling wirings provided in the signal layer, and formed on a first grid point; and a second signal via extending in a direction substantially perpendicular to the layers of the multilayered wiring substrate, the second signal via being connected to the other of the pair of differential signaling wirings, and formed on a second grid point that is positioned diagonally adjacent with respect to the first signal via.

The object and advantages of the invention will be realized and attained by means of the elements and combinations particularly pointed out in the claims. It is to be understood that both the foregoing general description and the following detailed description are exemplary and explanatory and are not restirctive of the invention, as claimed.

### BRIEF DESCRIPTION OF THE DRAWINGS

FIG. 1 is an explanatory view illustrating an example of an arrangement relationship of a signal via pair of a multilayered wiring substrate according to a first embodiment in which a portion is omitted;
FIG. 2 is a cross-sectional view taken along dot-dashed line A-A of FIG. 1;
FIGs. 3A to 3D illustrate explanatory views that compare calculation results of crosstalk between the first embodiment and a comparative example 1;
FIG. 4A to 4C are explanatory views illustrating an example of a position relationship between the multilayered wiring substrate of the first embodiment and pads of a semiconductor chip to be mounted;
FIG. 5 is an explanatory view illustrating an example of an arrangement relationship of signal via pairs of a multilayered wiring substrate according to a second embodiment in which a portion is omitted;
FIG. 6 is a cross-sectional view taken along line B-B of FIG. 5;
FIGs. 7A to 7D illustrate explanatory views that compare calculation results of crosstalk between the second embodiment and a comparative example 2:
FIG. 8 is an explanatory view illustrating an example of an arrangement relationship of signal via pairs of a multilayered wiring substrate of the comparative example 2;
FIG. 9 is an explanatory view illustrating an example of an arrangement relationship of signal via pairs of a multilayered wiring substrate according to a third embodiment in which a portion is omitted;
FIGs. 10A to 10D illustrate explanatory views that compare calculation results of crosstalk between the third embodiment and a comparative example 2;
FIG. 11 is an explanatory view illustrating an example of an arrangement relationship of signal via pairs of a multilayered wiring substrate according to a fourth embodiment in which a portion is omitted;
FIG. 12 is an explanatory view illustrating an example of a signal via pair of the fourth embodiment;
FIGs. 13A to 13D illustrate explanatory views that compare calculation results of crosstalk between the fourth embodiment and a comparative example 3;
FIG. 14 is an explanatory view illustrating an example of an arrangement relationship of signal via pairs of a multilayered wiring substrate according to a fifth embodiment in which a portion is omitted;
FIG. 15 is an explanatory view illustrating an example of a signal via pair according to the fifth embodiment;
FIG. 16A to 16D illustrates explanatory views that compare calculation results of crosstalk between the fifth embodiment and a comparative example 4;
FIG. 17 is an explanatory view illustrating an example of an arrangement relationship of signal via pairs of a multilayered wiring substrate of which a portion is omitted;
FIG. 18 is an explanatory view illustrating an example of a signal via pair; and
FIG. 19 is a cross-sectional view taken along line D-D of FIG. 18 of which a portion is omitted.

### DESCRIPTION OF EMBODIMENTS

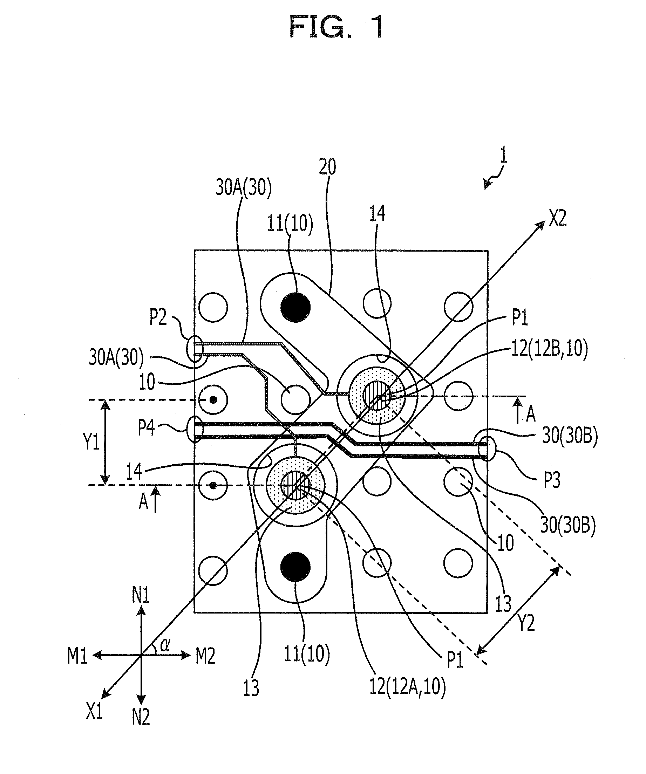

Hereinafter, embodiments of a multilayered wiring substrate and an electronic apparatus according to the present disclosure will be described in detail with reference to the accompanying drawings. The disclosed technology is not limited to the present embodiments. In the embodiments described below, the 2-dimensional relative positions of each element such as, for example, vias within the multilayered wiring substrate are represented with the up and down directions denoted by N1 and N2, respectively, and the left and right directions denoted by M1 and M2, respectively, as illustrated in FIG. 1. A lower-left direction and an upper-right direction in the drawing are denoted by X1 and X2. The X1-X2 axis and the M1-M2 axis intersect with an angle of α degrees. For example, 0° < α ≤ 45°.

In FIG. 1, for example, without being limited to the X1-X2 axis, the 2-dimensional relative positions of each element in the multilayered wiring substrate may be represented based on an axis representing a lower-right direction and an upper-left direction that is axially symmetric to the X1-X2 axis with respect to the N1-N2 axis. In the embodiments described below, each element such as, for example, signal vias within the multilayered wiring substrate are disposed in a grid pattern along the M1-M2 axis and the N1-N2 axis at a given pitch. The X1-X2 axis is at an angle with respect to the given pitch. In the embodiments as described below, the diameter of a differential signaling via indicates an approximately maximum diameter of a horizontal cross-section of the differential signaling via. The diameter of a clearance indicates an approximately maximum diameter of a horizontal cross-section of the clearance.

### [first embodiment]

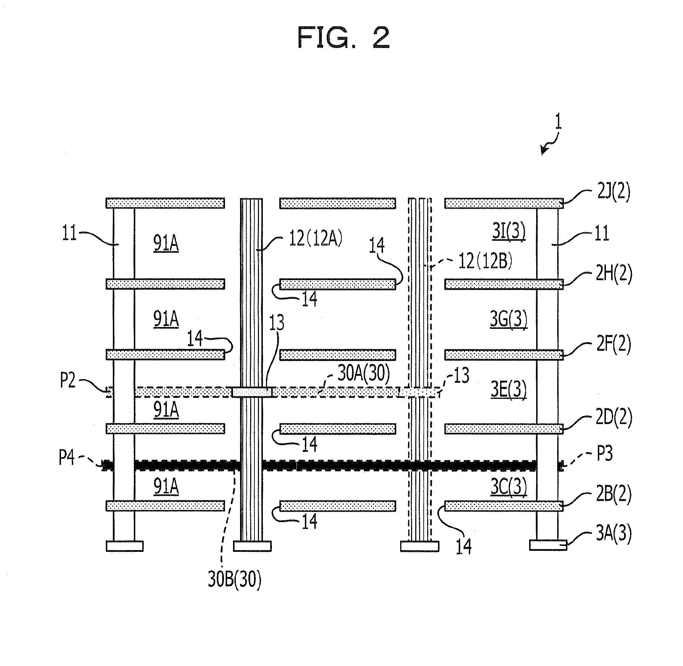

FIG. 1 is an explanatory view illustrating an example of an arrangement relationship of a signal via pair of a multilayered wiring substrate according to a first embodiment in which a portion is omitted. FIG. 2 is a cross-sectional view taken along line A-A of FIG. 1.

A multilayered wiring substrate 1 as illustrated in FIG. 2 has a multilayered structure, for example, a structure that includes eighteen (18) layers, in which a plurality of ground layers 2 and a plurality of signal layers 3 are sequentially layered using an insulation material 91A.. For example, in the multilayered wiring substrate 1, a first signal layer 3A, a second ground layer 2B, a third signal layer 3C, a fourth ground layer 2D, a fifth signal layer 3E, a sixth ground layer 2F and a seventh signal layer 3G are sequentially layered in this order. Furthermore, in the multilayered wiring substrate 1, a seventh signal layer 3G, an eighth ground layer 2H, a ninth signal layer 3I, and a tenth ground layer 2J are sequentially layered in this order. For the convenience of description, illustration of an eleventh to an eighteenth layer will be omitted. A fourteenth layer, a sixteenth layer and the eighteenth layer are designated as, for example, a signal layer 3.

A via 10 is formed by filling a hole that extends in a direction perpendicular to the layered surfaces of the ground layer 2 and the signal layer 3 with a conductive material such as, for example, copper, but the hole needs not to be fully filled and may be conductively connected to a layer that is to be connected. As illustrated in FIG. 1, a plurality of vias 10 are formed in a grid pattern on the layered surface at a given pitch. Each of the layers within the multilayered wiring substrate 1 is connected with each other by each of the vias 10.

The plurality of vias 10 include ground vias 11 and differential signaling vias 12. A differential signaling via 12 is an example of a signal via. A ground via 11 is connected to a ground layer 2. A differential signaling via 12 is connected to a signal layer 3 through a signal area 13. For the convenience of description, a ground via 11 is represented by a black circle, and a differential signaling via 12 is represented by a hatched circle in FIG. 1.

A signal via pair 20 includes a pair of differential signaling vias 12 constituted by a pair of vias 10 adjacent to each other along the X1-X2 axis as illustrated in FIG. 1 and a pair of ground vias 11 adjacent to the pair of differential signaling vias 12, out of the plurality of vias 10 disposed in a grid pattern. The pair of ground vias 11 within the signal via pair 20 are constituted by vias 10 that are adjacent to the differential signaling vias 12 within the signal via pair 20, and thus may be changed as appropriate. Moreover, the signal via pair 20 is connected to, for example, a ball grid array (BGA) or a land grid array (LGA). The pair of differential signaling vias 12 are constituted by, for example, a pair of vias 10 adjacent to each other along an axis inclined with respect to the pitch, that is, the X1-X2 axis.

A clearance 14, which prevents an electrical short between a ground layer 2 and a differential signaling via 12 and has a diameter larger than that of a differential signaling via 12, is formed in the ground layer 2 through which the differential signaling via 12 within the signal via pair 20 is inserted through. The clearance 14 is formed at a position that does not contact a differential signaling via 12.

When wiring is led out from the differential signaling vias 12 of the signal via pair 20, a differential pair 30 is disposed in a direction in which the wiring is led out, and the wiring is led out from the differential signaling vias 12 using the differential pair 30. The differential pair 30 is an example of signal wiring.

The multilayered wiring substrate 1 as illustrated in FIG. 2 includes a first differential pair 30A configured to lead out wiring from the differential signaling via 12 of the signal via pair 20 and a second differential pair 30B configured to lead out wiring from differential signaling vias 12 of an unillustrated signal via pair 20. As illustrated in FIG. 2, the second differential pair 30B is disposed in the third signal layer 3C that is between the second ground layer 2B and the fourth ground layer 2D, and passes between the differential signaling vias 12 that are within the signal via pair 20. The first differential pair 30A is disposed in the fifth signal layer 3E that is between the fourth ground layer 2D and the sixth ground layer 2F, and is led out from the differential signaling vias 12 that are within the signal via pair 20.

The differential signaling vias 12 within the signal via pair 20 includes a first differential signaling via 12A and a second differential signaling via 12B. The first differential signaling via 12A is connected to one of the wires that make up the first differential pair 30A disposed in the signal layer 3 and is formed at a first grid point in the grid pattern. The second differential signaling via 12B is connected to the other wire that makes up the first differential pair 30A disposed in the signal layer 3 and is formed at a second grid point that is diagonally positioned with respect to the first differential signaling via 12A. A distance Y2 between a central point of the first differential signaling via 12A and a central point of the second differential signaling via 12B is longer than the shortest distance Y1 between the central points of the signal vias 10 connected to the first differential pair 30A, respectively. The first differential signaling via 12A and the second differential signaling via 12B are disposed so that the central point of the first differential signaling via 12A is spaced apart from the central point of the second differential signaling via 12B by the distance Y2. The distance Y2 between the central point of the first differential signaling via 12A and the central point of the second differential signaling via 12B is shorter than a distance that is twice the shortest distance Y1.

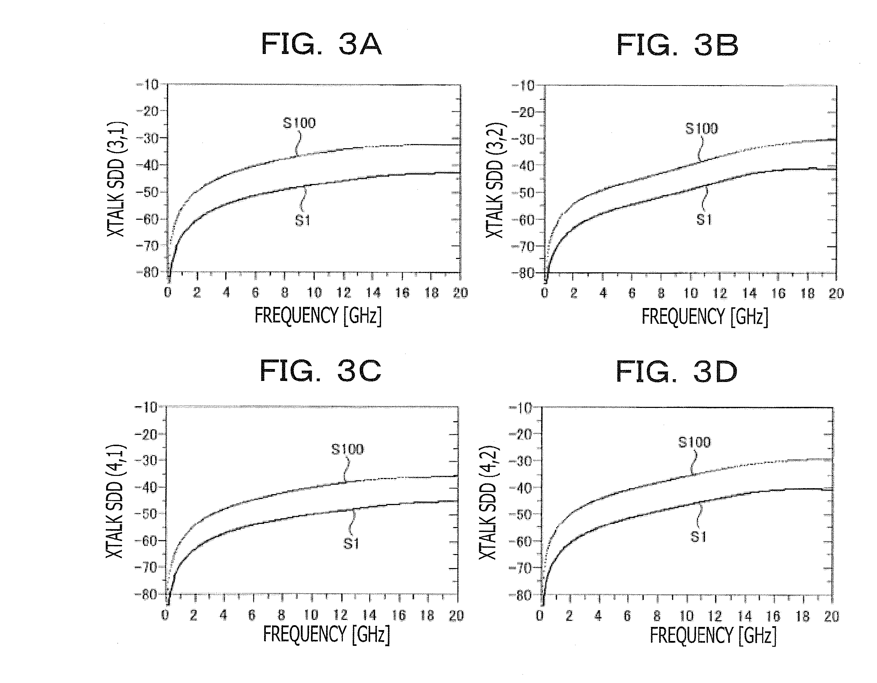

FIGs. 3A to 3D are explanatory views that compare calculation results of crosstalk between the first embodiment and a comparative example 1. The diameter of a via 10 was set at approximately 0.25 mm, the diameter of a differential signaling via 12 was set at approximately 0.2 mm, and the pitch between the vias 10 disposed in a grid pattern was set at approximately 1 mm. Moreover, the calculation was performed under conditions where the diameter of a clearance 14 was approximately 0.8 mm, the thickness of the copper of a signal layer 3 was 30 µm, and the thickness of a ground layer 2 was zero (0) as an ideal ground. The pitch between the vias 10 was the distance from the center of a via 10 to the center of an adjacent via 10.

FIG 3 illustrates the calculation results of crosstalk for four sections. The sections are defined by ports, which are defined as follows. A first port P1 is a surface layer (the eighteenth signal layer) of the differential signaling vias 12 within the signal via pair 20. A second port P2 is the ends of the first differential pair 30A on the M1 side, as illustrated in FIG. 1. A third port P3 is the ends of the second differential pair 30B on the M2 side, as illustrated in FIG. 1. A fourth port P4 is the ends of the second differential pair 30B on the M1, as illustrated in FIG. 1.

The S-parameters of the crosstalk are indicated by the S-parameters of a mixed mode in which a differential mode and a common mode are mixed. In the comparative example 1, as illustrated in FIGS. 17 and 18, a substrate is used in which, among the plurality of vias 110 that are disposed in a grid pattern at a given pitch, the differential pair 130 passes between a pair of differential signaling vias 112 that are adjacent to each other along the N1-N2 axis.

Xtalk Sdd (3, 1), as illustrated in FIG. 3A, represents a calculation result for the crosstalk between the first port P1 and the third port P3 in a first section in which the first port P1 serves as an input port and the third port P3 serves as an output port. The crosstalk S1 between the first port P1 and the third port P3 in the first embodiment is approximately 10 dB less than the crosstalk S100 between the first port P1 and the third port P3 in the comparative example 1 in most of the frequency bands displayed.

Xtalk Sdd (3, 2), as illustrated in FIG. 3B, represents a calculation result for the crosstalk between the second port P2 and the third port P3 in a second section in which the second port P2 serves as an input port and the third port P3 serves as an output port. The crosstalk S1 between the second port P2 and the third port P3 in the first embodiment is approximately 10 dB less than the crosstalk S100 between the second port P2 and the third port P3 in the comparative example 1 in most of the frequency bands displayed.

Xtalk Sdd (4, 1), as illustrated in FIG. 3C, represents a calculation result for the crosstalk between the first port P1 and the fourth port P4 in a third section in which the first port P1 serves as an input port and the fourth port P4 serves as an output port. The crosstalk S1 between the first port P1 and the fourth port P4 in the first embodiment is approximately 10 dB less than the crosstalk S100 between the first port P1 and the fourth port P4 in the comparative example 1 in most of the frequency bands displayed.

Xtalk Sdd (4, 2), as illustrated in FIG. 3D, represents a calculation result of the crosstalk between the second port P2 and the fourth port P4 in a fourth section in which the second port P2 serves as an input port and the fourth port P4 serves as an output port. The crosstalk S1 between the second port P2 and the fourth port P4 in the first embodiment is approximately 10 dB less than the crosstalk S100 between the second port P2 and the fourth port P4 in the comparative example 1 in most of the frequency bands displayed.

In the first embodiment, the pair of differential signaling vias 12 of the signal via pair 20 is constituted by a pair of vias 10 adjacent to each other along the X1-X2 axis among the plurality of vias 10 that are disposed in a grid pattern at a given pitch. The first differential signaling via 12A is formed on a first grid point within the grid, and the second differential signaling via 12B is formed on a second grid point that is diagonally positioned with respect to the first differential signaling via 12A. That is, the distance Y2 between the pair of differential signaling vias 12 of the signal via pair 20 is longer that the distance Y1 between a pair of differential signaling vias 12 adjacent to each other along either the N1-N2 axis or the M1-M2 axis. As a result, the crosstalk between the pair of differential signaling vias 12 of the signal via pair 20 may be decreased. Even when the differential pair 30 passes between the pair of differential signaling vias 12, the crosstalk may be less than the crosstalk in the comparative example 1.

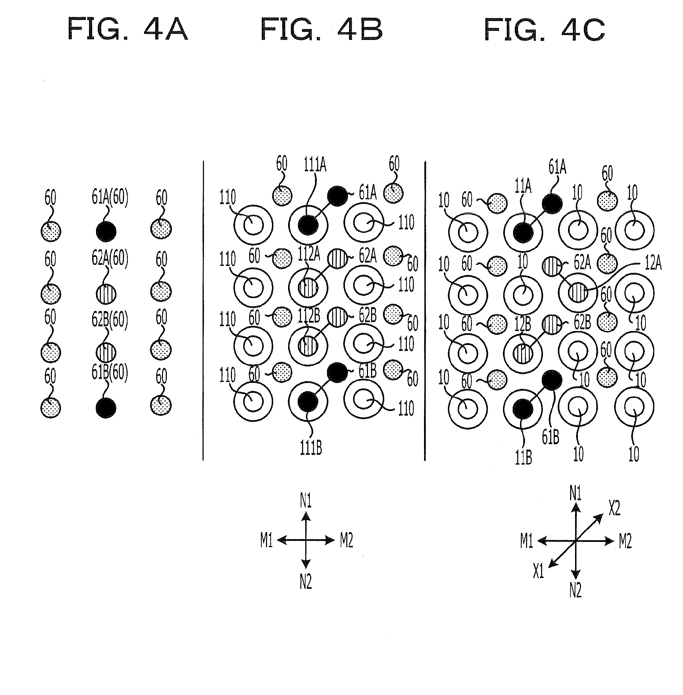

FIGs. 4A to 4C illustrate explanatory views illustrating a position relationship between the multilayered wiring substrate 1 of the first embodiment and a pad of a semiconductor chip that is mounted. Pads 60 of the semiconductor chip that is mounted on the multilayered wiring substrate 1 are illustrated in FIG. 4A. The pads 60 in the second column of the semiconductor chip include a first ground pad 61A, a first signal pad 62A, a second signal pad 62B and a second ground pad 61B.

The signal via pair 120 of the multilayered wiring substrate 100 of comparative example 1 includes, among the plurality of vias 110, a pair of differential signaling vias 112 adjacent to each other along the N1-N2 axis and a pair of ground vias 111, as illustrated in FIG. 4B. The signal via pair 120 includes a first ground via 111A, a first differential signaling via 112A, a second differential signaling via 112B and a second ground via 111B. Mounting the semiconductor chip on the multilayered wiring substrate 100 is performed as illustrated in FIG. 4B. That is, the first ground pad 61A is connected to the first ground via 111A and the first signal pad 62A is connected to the first differential signaling via 112A by, for example, solder balls. The second signal pad 62B is connected to the second differential signaling via 112B and the second ground pad 61B is connected to the second ground via 111B by, for example, solder balls. As a result, the semiconductor chip may be mounted on the multilayered wiring substrate 100.

In contrast, the signal via pair 20 of the multilayered wiring substrate 1 of the first embodiment includes, among the plurality of vias 10, a pair of differential signaling vias 12 that are adjacent to each other along the X1-X2 axis and a pair of ground vias 11, as illustrated in FIG. 4C. The signal via pair 20 includes a first ground via 11A, a first differential signaling via 12A, a second differential signaling via 12B and a second ground via 11B. Mounting of the semiconductor chip on the multilayered wiring substrate 1 is performed as illustrated in FIG. 4C. That is, the first ground pad 61A is connected to the first ground via 11A and the first signal pad 62A is connected to the first differential signaling via 12A by, for example, solder balls. The second signal pad 62B is connected to the second differential signaling via 12B and the second ground pad 61B is connected to the second ground via 11B by, for example, solder balls. As a result, the semiconductor chip may be mounted on the multilayered wiring substrate 1.

Although the multilayered wiring substrate 1 according to the first embodiment includes the signal via pair 20, which includes the pair of differential signaling vias 12A and 12B that are adjacent to each other along the X1-X2 axis, the semiconductor chip may be mounted on the above multilayered wiring substrate 1 using the pad positions of a conventional semiconductor chip without changing the pad design. As a result, an electronic apparatus in which a semiconductor chip is mounted on the multilayered wiring substrate 1 may be provided.

Next, an exemplary embodiment of a multilayered wiring substrate 1 in which each signal via pair 20, which includes a first differential signaling via 12A and a second differential signaling via 12B that are adjacent to each other along the X1-X2 axis, is disposed in parallel will be described below as a second embodiment.

### [second embodiment]

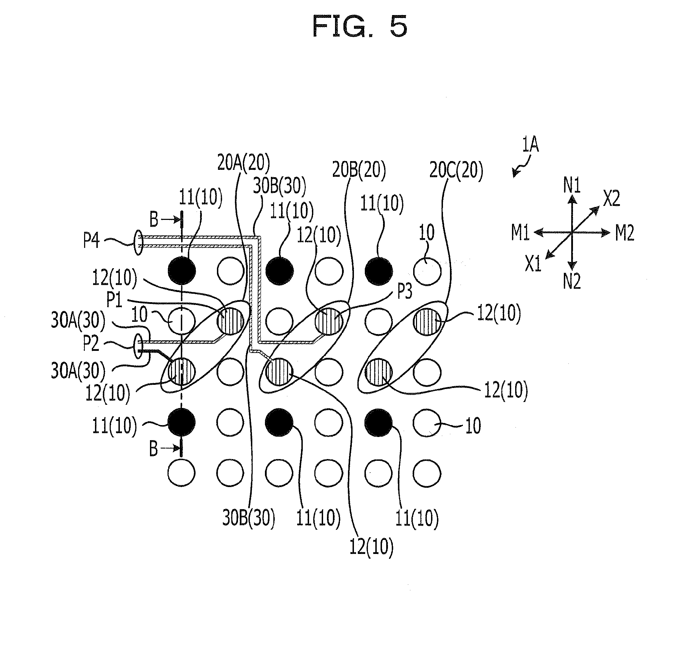

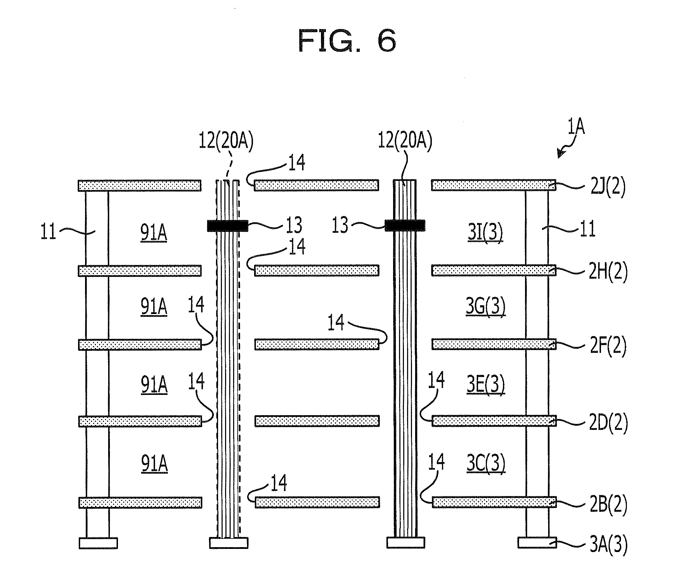

FIG. 5 is an explanatory view illustrating an example of an arrangement relationship of signal via pairs of a multilayered wiring substrate according to a second embodiment in which a portion is omitted. FIG. 6 is a cross-sectional view taken along line B-B of FIG. 5.

In a multilayered wiring substrate 1A as illustrated in FIG. 6, a first signal layer 3A, a second ground layer 2B, a third signal layer 3C, a fourth ground layer 2D, a fifth signal layer 3E, a sixth ground layer 2F, and a seventh signal layer 3G are sequentially layered in this order. In the multilayered wiring substrate 1A, an eighth ground layer 2H, a ninth signal layer 3I, and a tenth ground layer 2J are sequentially layered in this order on the seventh signal layer 3G. For the convenience of description, illustration of an eleventh layer to an eighteenth layer is omitted. A fourteenth layer, a sixteenth layer and the eighteenth layer are designated as, for example, a signal layer 3.

The multilayered wiring substrate 1A illustrated in FIG. 5 includes a first signal via pair 20A, a second signal via pair 20B and a third signal via pair 20C. The first signal via pair 20A, the second signal via pair 20B and the third signal via pair 20C are adjacently disposed in parallel. A clearance 14 that prevents an electrical short between a ground layer 2 and a differential signaling via 12, and has a diameter larger than the diameter of the differential signaling via 12, is formed in the ground layer 2 through which a differential signaling via 12 within the signal via pair 20 is inserted through. The clearance 14 is formed at a position that does not contact with a differential signaling via 12.

When wiring is led out from differential signaling vias 12 of the signal via pair 20, the differential pair 30 is disposed in a direction where the wiring is led out, and the wiring is led out from the differential signaling via 12 using the differential pair 30.

The multilayered wiring substrate 1A as illustrated in FIG. 5 includes a first differential pair 30A configured to lead out the wiring from the differential signaling via 12 of the first signal via pair 20A and a second differential pair 30B configured to lead out the wiring from the differential signaling via 12 of the second signal via pair 20B. The first differential pair 30A is disposed on, for example, the third signal layer 3C that is between the second ground layer 2B and the fourth ground layer 2D. The second differential pair 30B is disposed on, for example, the fifth signal layer 3E that is between the fourth ground layer 2D and the sixth ground layer 2F.

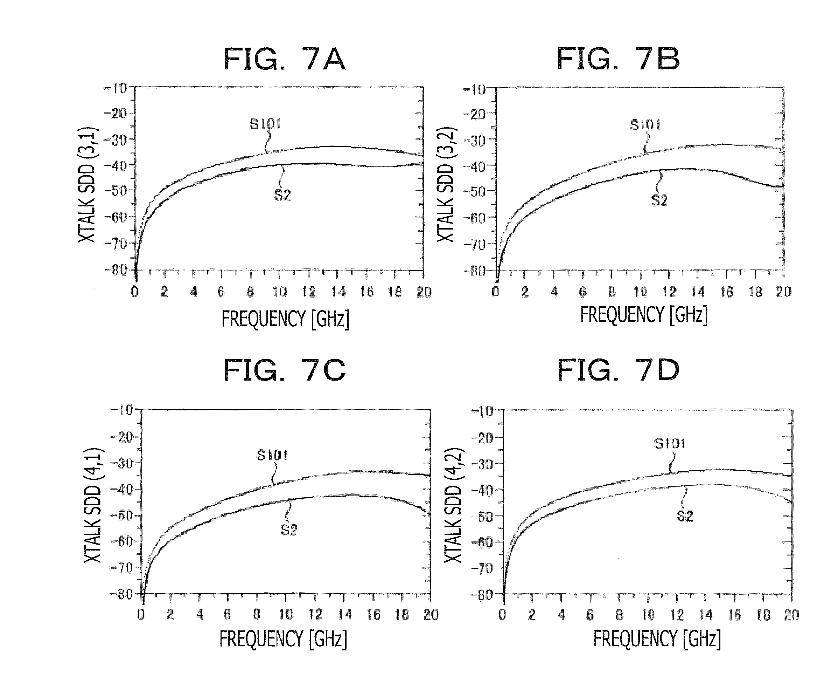

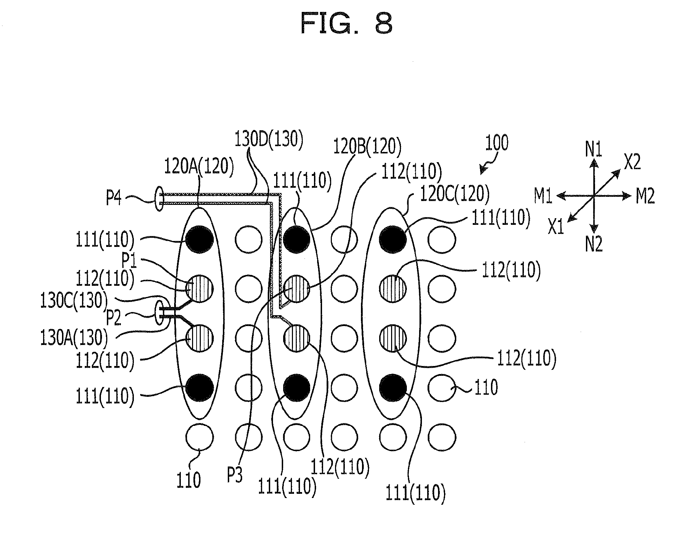

FIGs. 7A to 7D illustrate explanatory views of a comparison of calculation results for the crosstalk between the second embodiment and a comparative example 2. The diameter of a via 10 was set at approximately 0.25 mm, the diameter of a differential signaling via 12 was set at approximately 0.2 mm, and the pitch between the vias 10 disposed in a grid pattern was set at approximately 1 mm. The calculation was performed under conditions where the diameter of a clearance 14 was approximately 0.8 mm, the thickness of the copper of a signal layer 3 was 30 µm, and the thickness of a ground layer 2 was zero (0) as an ideal ground. The pitch between the vias 10 is the distance from the center of a via 10 to the center of an adjacent via 10. FIG. 8 is an explanatory view illustrating an example of an arrangement relationship of signal via pairs of a multilayered wiring substrate 100 of the comparative example 2. The same elements as those of the multilayered wiring substrate 100 of FIG. 17 are denoted by the same reference numeral, and descriptions of repeated elements and operations are omitted. The multilayered wiring substrate 100 as illustrated in FIG. 8 includes a first differential pair 130C configured to lead out the wiring from the differential signaling vias 112 of the first signal via pair 120A and a second differential pair 130D configured to lead out the wiring from the differential signaling vias 112 of the second signal via pair 120B.

For the second embodiment, the targets of interest were a first signal via pair 20A and a second signal via pair 20B each constituted by a pair of differential signaling vias 12 adjacent to each other along the X1-X2 axis of the multilayered wiring substrate 1A. Conversely, for the comparative example 2 the targets of interest were a first signal via pair 120A and a second signal via pair 120B each constituted by a pair of differential signaling vias 112 adjacent to each other along the N1-N2 axis of the multilayered wiring substrate 100 as illustrated in FIG. 8.

FIG. 7 illustrates the calculation results of the crosstalk of four sections. The sections are defined by ports, which are defined as follows. A first port P1 is a surface layer (the eighteenth signal layer) of a differential signaling vias 12 within the first signal via pair 20A. A second port P2 is the ends of a first differential pair 30A on the M1 side, as illustrated in FIG. 5. A third port P3 is a surface layer (the eighteenth signal layer) of the differential signaling vias 12 within the second signal via pair 20B. A fourth port P4 is the ends of a second differential pair 30B on the M1 side, as illustrated in FIG. 5. The S-parameters of the crosstalk are indicated by S-parameters of a mixed mode in which a differential mode and a common mode are mixed.

Xtalk Sdd (3, 1), as illustrated in FIG. 7A, represents a calculation result for the crosstalk between the first port P1 and the third port P3 in a first section in which the first port P1 serves as an input port and the third port P3 serves as an output port. The crosstalk S2 between the first port P1 and the third port P3 in the second embodiment is several dB less than the crosstalk S101 between the first port P1 and the third port P3 in the comparative example 2 for most frequency bands displayed.

Xtalk Sdd (3, 2), as illustrated in FIG. 7B, represents a calculation result for the crosstalk between the second port P2 and the third port P3 in a second section in which the second port P2 serves as an input port and the third port P3 serves as an output port. The crosstalk S2 between the second port P2 and the third port P3 in the second embodiment is approximately 20 dB less than the crosstalk S101 between the second port P2 and the third port P3 in the comparative example 2 in frequency bands of about 12 GHz to 20GHz.

Xtalk Sdd (4, 1), as illustrated in FIG. 7C, represents a calculation result of the crosstalk between the first port P1 and the fourth port P4 in a third section in which the first port P1 serves as an input port and the fourth port P4 serves as an output port. The crosstalk S2 between the first port P1 and the fourth port P4 in the second embodiment is approximately 15 dB less than the crosstalk S101 between the first port P1 and the fourth port P4 in the comparative example 2 in most frequency bands.

Xtalk Sdd (4, 2), as illustrated in FIG. 7D, represents a calculation result of the crosstalk between the second port P2 and the fourth port P4 in a fourth section in which the second port P2 serves as an input port and the fourth port P4 serves as an output port. The crosstalk S2 between the second port P2 and the fourth port P4 in the second embodiment is approximately 10 dB less than the crosstalk S101 between the second port P2 and the fourth port P4 in the comparative example 2 in most frequency bands displayed.

In the second embodiment, the first signal via pair 20A and the second signal via pair 20B, each including a pair of differential signaling vias 12 adjacent to each other along the X1-X2 axis among the plurality of vias 10 disposed in a grid pattern at a given pitch, are adjacently disposed in parallel. The distance between the signal via pair in the second embodiment is longer than the distance between the signal via pair when the signal via pair includes a pair of differential signaling vias that are disposed adjacent to each other along the N1-N2 axis or along the M1-M2 axis. As a result, crosstalk when the signal via pairs 20 including the pair of differential signaling vias 12 adjacent to each other along the X1-X2 axis are disposed in parallel may be less than the crosstalk for the signal via pairs that include a pair of differential signaling vias adjacent to each other along the N1-N2 axis or along the M1-M2 axis (the comparative example 2).

### [third embodiment]

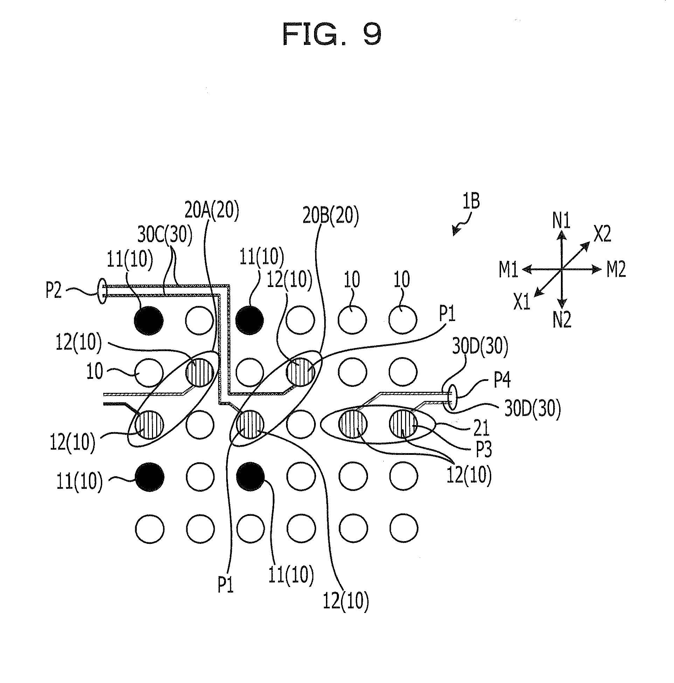

Next, a multilayered wiring substrate of a third embodiment will be described. FIG. 9 is an explanatory view illustrating an example of an arrangement relationship of signal via pairs of a multilayered wiring substrate according to a third embodiment in which a portion of is omitted. The same elements as those of the multilayered wiring substrate 1 of the first embodiment are denoted by the same reference numeral, and descriptions of repeated elements and operations are omitted.

A multilayered wiring substrate 1B as illustrated in FIG. 9 includes a first signal via pair 20A, a second signal via pair 20B and a fourth signal via pair 21. The fourth signal via pair 21 includes a pair of differential signaling vias 12 constituted by a pair of vias 10 adjacent to each other along the M1-M2 axis and a pair of ground vias 11 with both of the pair of differential signaling vias 12 interposed therebetween, among a plurality of vias 10 disposed in a grid pattern at a given pitch. The pair of ground vias 11 within the signal via pair 21 are formed of vias 10 adjacent to the pair of differential signaling vias 12 within the signal via pair 21, and thus, may be appropriately changed. The first signal via pair 20A and the second signal via pair 20B are adjacently disposed in parallel. The second signal via pair 20B and the fourth signal via pair 21 are adjacently disposed.

The multilayered wiring substrate 1B as illustrated in FIG. 9 includes a third differential pair 30C configured to lead out the wiring from the differential signaling via 12 of the second signal via pair 20B and a fourth differential pair 30D configured to lead out the wiring from the differential signaling via 12 of the fourth signal via pair 21. The third differential pair 30C is disposed in, for example, a third signal layer 3C that is between a second ground layer 2B and a fourth ground layer 2D. The fourth differential pair 30D is disposed in, for example, a fifth signal layer 3E that is between the fourth ground layer 2D and a sixth ground layer 2F.

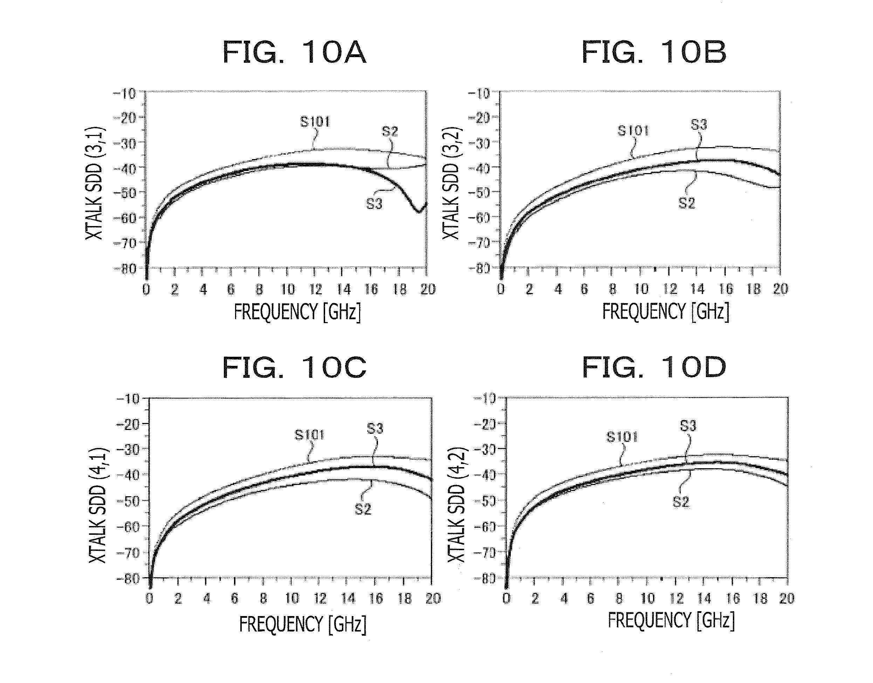

FIGs. 10A to 10D are explanatory views that compare calculation results of the crosstalk between the third embodiment and the comparative example 2. For the third embodiment, the targets of interest were the second signal via pair 20B that includes a pair of differential signaling vias 12 adjacent to each other along the X1-X2 axis of the multilayered wiring substrate 1B and the fourth signal via pair 21 that includes a pair of differential signaling vias 12 adjacent to each other along the M1-M2 axis. Xtalk Sdd (3, 1), Xtalk Sdd (4, 1), Xtalk Sdd (3, 2) and Xtalk Sdd (4, 2), as illustrated in FIGS. 10A to 10D, respectively, are the same as those illustrated in FIGS. 7A to 7D, respectively.

A first port P1 is the surface layer (the eighteenth signal layer) of a differential signaling via 12 that is within the second signal via pair 20B. A second port P2 is the ends of a third differential pair 30C on the M1 side, as illustrated in FIG. 9. A third port P3 is the surface layer (the eighteenth signal layer) of the differential signaling via 12 that is within the fourth signal via pair 21. A fourth port P4 is the ends of a fourth differential pair 30D on the M2 side, as illustrated in FIG. 9.

Referring to FIG. 10A, the crosstalk S3 between the first port P1 and the third port P3 in the third embodiment is approximately 10 dB less than the crosstalk S101 between the first port P1 and the third port P3 in the comparative example 2 in most frequency bands displayed.

Referring to FIG. 10B, the crosstalk S3 between the second port P2 and the third port P3 in the third embodiment approximately 10 dB less than the crosstalk S101 between the second port P2 and the third port P3 in the comparative example 2 in most frequency bands displayed.

Referring to FIG. 10C, the crosstalk S3 between the first port P1 and the fourth port P4 in the third embodiment is approximately 5 dB less than the crosstalk S101 between the first port P1 and the fourth port P4 in the comparative example 2 in most frequency bands displayed.

Referring to FIG. 10D, the crosstalk S3 between the second port P2 and the fourth port P4 in the third embodiment is approximately 5 dB less than the crosstalk S101 between the second port P2 and the fourth port P4 in the comparative example 2 in most frequency bands displayed.

In the third embodiment, among the plurality of vias 10 disposed in a grid pattern with a given pitch, the first signal via pair 20A that includes a pair of differential signaling vias 12 adjacent to each other along the X1-X2 axis and the fourth signal via pair 21 that includes a pair of differential signaling vias 12 adjacent to each other along the M1-M2 axis are adjacently disposed. The distance between the signal via pairs in the third embodiment is longer than the distance between signal via pairs when the signal via pairs that includes a pair of differential signaling vias adjacent to each other along the N1-N2 axis or along the M1-M2 axis are adjacently disposed. As a result, the crosstalk when the signal via pair 20 that includes the pair of differential signaling vias 12 adjacent to each other along the X1-X2 axis and the signal via pair 21 that includes the pair of differential signaling vias adjacent to each other along the M1-M2 axis are adjacently disposed, may be less than the comparative example 2.

In the third embodiment, the case in which the second signal via pair 20B and the fourth signal via pair 21 are adjacently disposed has been described. However, even if the fourth signal via pair 21 is changed to a signal via pair that includes a pair of differential signaling vias 12 adjacent to each other along the N1-N2 axis, the same effect may be achieved.

### [fourth embodiment]

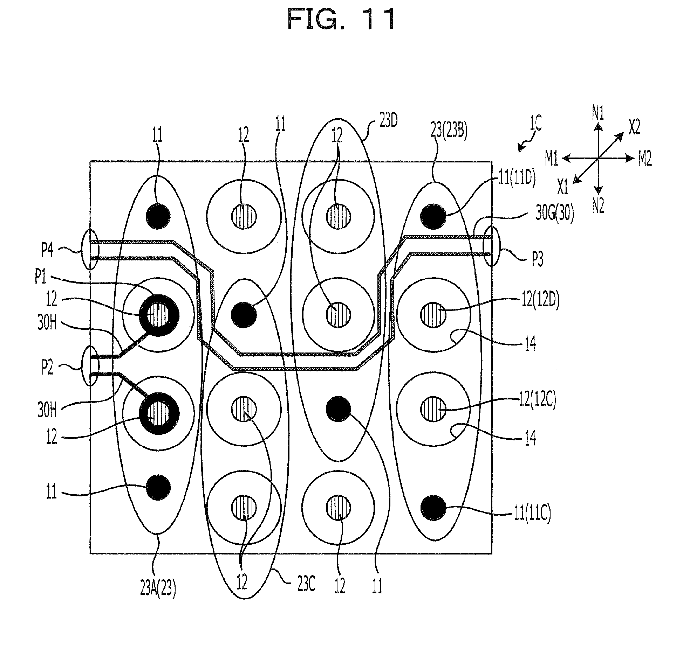

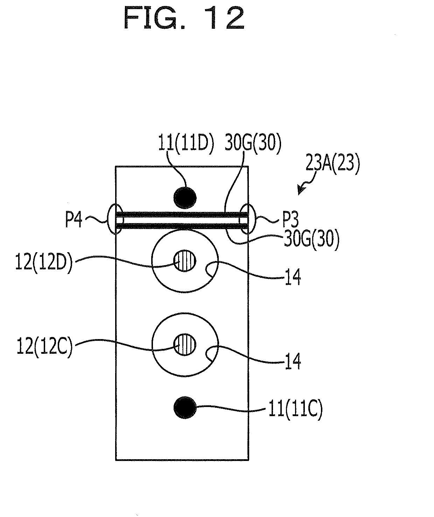

Next, a multilayered wiring substrate of a fourth embodiment will be described. FIG. 11 is an explanatory view illustrating an example of an arrangement relationship of signal via pairs of a multilayered wiring substrate according to a fourth embodiment in which a portion is omitted. FIG. 12 is an explanatory view illustrating an example of a signal via pair according to the fourth embodiment. The same elements as those of the multilayered wiring substrate 1 of the first embodiment are denoted by the same reference numerals, and descriptions of repeated elements and operations are omitted.

A signal via pair 23 of a multilayered wiring substrate 1C as illustrated in FIG. 11 includes, among a plurality of vias 10 disposed in a grid pattern at a given pitch, a pair of differential signaling vias 12 that are made up of a pair of vias 10 adjacent to each other along the N1-N2 axis and a pair of ground vias 11 that have the pair of differential signaling vias 12 interposed therebetween. The ground vias 11 may be appropriately changed to vias 10 that are adjacent to the differential signaling vias 12 within the signal via pair 23.

A pair of differential signaling vias 12 include a first differential signaling via 12C and a second differential signaling via 12D. A pair of ground vias 11 include a first ground via 11C formed at a position adjacent to the first differential signaling via 12C and a second ground via 11D formed at a position adjacent to the second differential signaling via 12D.

The multilayered wiring substrate 1C includes a first signal via pair 23A, a second signal via pair 23B, a third signal via pair 23C and a fourth signal via pair 23D. A seventh differential pair 30G is disposed on signal layer 3, which is different from the signal layers that *the first to fourth signal via pairs 23A to 23D are disposed on,* and passes between a ground via 11 and a differential signaling via 12 that are within the second signal via pair 23B. The seventh differential pair 30G passes between a ground via 11 and a differential signaling via 12 that are within the fourth signal via pair 23D. The seventh differential pair 30G passes between a ground via 11 and a differential signaling via 12 that are within the third signal via pair 23C. The seventh differential pair 30G passes between a ground via 11 and a differential signaling via 12 within the first signal via pair 23A. The differential signaling via 12 within the first signal via pair 23A is connected to an eighth differential pair 30H disposed on signal layer 3 that is different from *the signal layer in which the first signal via pair 23A is disposed.*

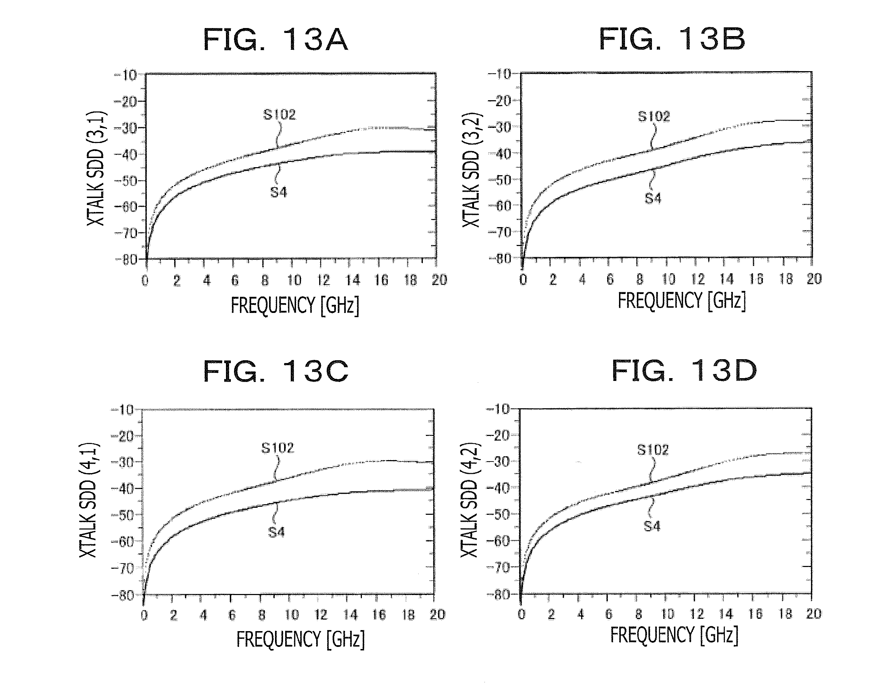

FIGs. 13A to 13D illustrate explanatory views of a comparison of calculation results for the crosstalk between the fourth embodiment and a comparative example 3. A first port P1 is a surface layer (the eighteenth signal layer) of a differential signaling via 12 that is within the first signal via pair 23A. A second port P2 is the ends of the eighth differential pair 30H on the M1 side, as illustrated in FIG. 11. A third port P3 is the ends of the seventh differential pair 30G on the M2 side, as illustrated in FIG. 11. A fourth port P4 is the ends of the seventh differential pair 30G on the M1 side, as illustrated in FIG. 11. In the comparative example 3, a substrate is used in which a differential pair 30 passes between the differential signaling vias 12 within the signal via pair 23. Xtalk Sdd (3, 1), Xtalk Sdd (4, 1), Xtalk Sdd (3, 2) and Xtalk Sdd (4, 2), as illustrated in FIGS. 13A to 13D, respectively, are the same as those illustrated in FIGS. 7A to 7D, respectively.

Referring to FIG. 13A, the crosstalk S4 between the first port P1 and the third port P3 in the fourth embodiment is approximately 5 dB to 10 dB less than the crosstalk S102 between the first port P1 and the third port P3 in the comparative example 3 in frequency bands of 10 GHz to 20GHz.

Referring to FIG. 13B, the crosstalk S4 between the second port P2 and the third port P3 in the fourth embodiment is approximately 5 dB to 10 dB less than the crosstalk S102 between the second port P2 and the third port P3 in the comparative example 3 in frequency bands of 2 GHz to 20GHz.

Referring to FIG. 13C, the crosstalk S4 between the first port P1 and the fourth port P4 in the fourth embodiment is approximately 5 dB to 10 dB less than the crosstalk S102 between the first port P1 and the fourth port P4 in the comparative example 3 in frequency bands of 2 GHz to 20GHz.

Referring to FIG. 13D, the crosstalk S4 between the second port P2 and the fourth port P4 in the fourth embodiment is approximately 5 dB to 10 dB less than the crosstalk S102 between the second port P2 and the fourth port P4 in the comparative example 3 in frequency bands of 2 GHz to 20GHz.

In the fourth embodiment, when a differential pair 30 passes through the signal via pair 23, the differential pair 30 passes between the differential signaling via 12 and the ground via 11 that are within the signal via pair 23. For example, the differential pair 30 passes between the first differential signaling via 12C and the first ground via 11C, or between the second differential signaling via 12D and the second ground via 11D. As a result, because one side of the signal via pair 23 in which the differential pair 30 passes therebetween is a ground via 11, crosstalk may be less than when the differential pair 30 passes between two differential signaling vias 12.

In the fourth embodiment, the pair of differential signaling vias 12 within the signal via pair 23 is formed of a pair of vias 10 that are adjacent to each other along the N1-N2 axis among the plurality of vias 10 disposed in a grid pattern at a given pitch. However, the pair of differential signaling vias 12 may be formed of a pair of vias 10 adjacent to each other along the M1-M2 axis or along the X1-X2 axis.

### [fifth embodiment]

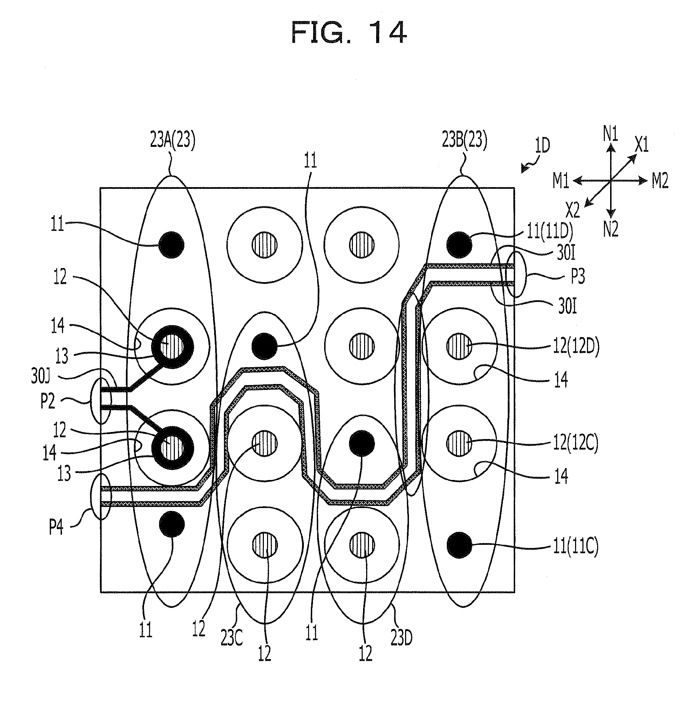

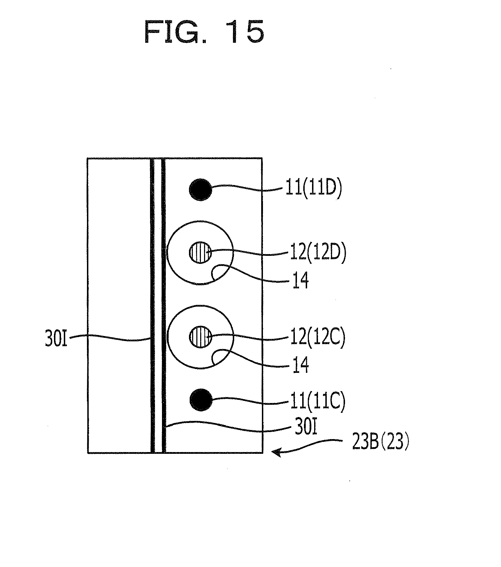

Next, a multilayered wiring substrate of a fifth embodiment will be described. FIG. 14 is an explanatory view illustrating an example of an arrangement relationship of signal via pairs of a multilayered wiring substrate according to a fifth embodiment in which a portion is omitted. FIG. 15 is an explanatory view illustrating an example of a signal via pair according to the fifth embodiment. The same elements as those of the multilayered wiring substrate 1 of the first embodiment are denoted by the same reference numerals, and descriptions of repeated elements and operations are omitted.

A signal via pair 23 of a multilayered wiring substrate 1D as illustrated in FIG. 14 includes, among a plurality of vias 10 disposed in a grid pattern at a given pitch, a pair of differential signaling vias 12 that are made up of a pair of vias 10 adjacent to each other along the N1-N2 axis and a pair of ground vias 11 that have the pair of differential signaling vias 12 interposed therebetween. A ground via 11 may be appropriately changed to a via 10 adjacent to a differential signaling via 12 within the signal via pair 23.

The multilayered wiring substrate 1D includes a first signal via pair 23A, a second signal via pair 23B, a third signal via pair 23C and a fourth signal via pair 23D. A ninth differential pair 30I disposed on signal layer 3, which is different to *the signal layers that the first to fourth signal via pairs 23A to 23D are disposed on,* passes between a ground via 11 and a differential signaling via 12 that are within the second signal via pair 23B. The ninth differential pair 30I passes in parallel to the pair of adjacent differential signaling vias 12 within the second signal via pair 23B. The ninth differential pair 30I passes between a ground via 11 and a differential signaling via 12 that are within the fourth signal via pair 23D. The ninth differential pair 30I passes between a ground via 11 and a differential signaling via 12 that are within the third signal via pair 23C. The ninth differential pair 30I passes between a ground via 11 and a differential signaling via 12 that are within the first signal via pair 23A. A differential signaling via 12 that is within the first signal via pair 23A is connected to a tenth differential pair 30J, which is disposed in the signal layer 3.

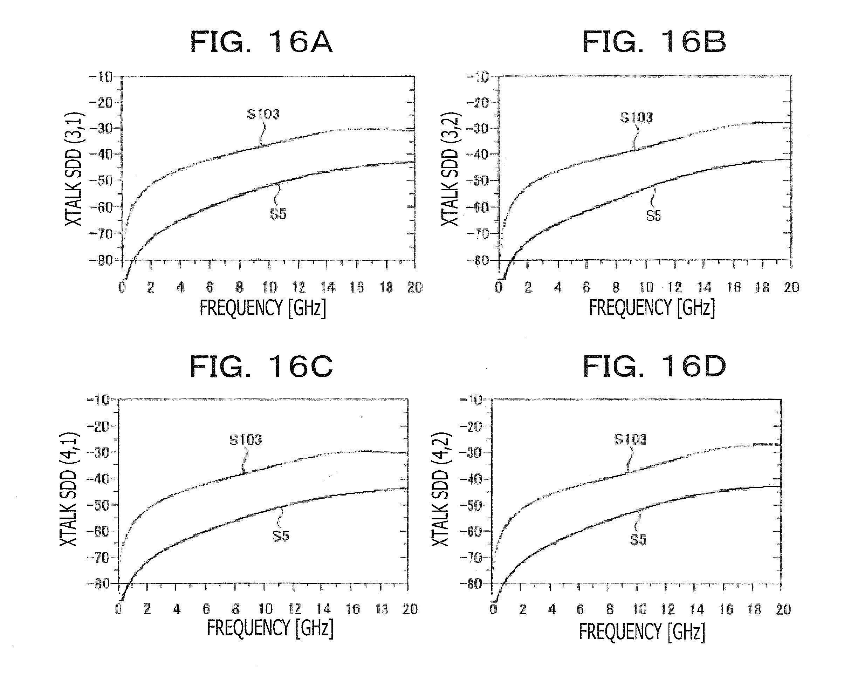

FIGs. 16A to 16D illustrate explanatory views of a comparison of calculation results of the crosstalk between the fifth embodiment and a comparative example 4. A first port P1 is a surface layer (the eighteenth signal layer) of a differential signaling via 12 that is within the first signal via pair 23A. A second port P2 is the ends of the tenth differential pair 30J on the M1 side, as illustrated in FIG. 14. A third port P3 is the ends of the ninth differential pair 30I on the M2 side, as illustrated in FIG. 14. A fourth port P4 is the ends of the ninth differential pair 30I on the M1 side, as illustrated in FIG. 14. In the comparative example 4, a substrate is used in which a differential pair 30 passes between the differential signaling vias 12 within the signal via pair 23. Xtalk Sdd (3, 1), Xtalk Sdd (4, 1), Xtalk Sdd (3, 2) and Xtalk Sdd (4, 2), as illustrated in FIGS. 16A to 16D, respectively, are the same as those illustrated in FIGS. 7A to 7D, respectively.

Referring to FIG. 16A, the crosstalk S5 between the first port P1 and the third port P3 in the fifth embodiment is approximately 10 dB to 15 dB less than the crosstalk S103 between the first port P1 and the third port P3 in the comparative example 4 in most frequency bands displayed.

Referring to FIG. 16B, the crosstalk S5 between the second port P2 and the third port P3 in the fifth embodiment is approximately 10 dB to 15 dB less than the crosstalk S103 between the second port P2 and the third port P3 in the comparative example 4 in most frequency bands displayed.

Referring to FIG. 16C, the crosstalk S5 between the first port P1 and the fourth port P4 in the fifth embodiment is approximately 10 dB to 15 dB less than the crosstalk S103 between the first port P1 and the fourth port P4 in the comparative example 4 in most frequency bands displayed.

Referring to FIG. 16D, the crosstalk S5 between the second port P2 and the fourth port P4 in the fifth embodiment is approximately 10 dB to 15 dB less than the crosstalk S103 between the second port P2 and the fourth port P4 in the comparative example 4 in most frequency bands displayed.

In the fifth embodiment, when the differential pair 30 passes through a signal via pair 23, the differential pair 30 passes between a differential signaling via 12 and a ground via 11 that are within the signal via pair 23, and passes in parallel to a pair of differential signaling vias 12 within the signal via pair 23. As a result, crosstalk may be less than when the differential pair 30 passes between two differential signaling vias 12.

In the fifth embodiment, an electromagnetic field is coupled between the pair of differential signaling vias 12 within the signal via pair 23. Accordingly, when the differential pair 30 passes between the pair of differential signaling vias 12, crosstalk is relatively high. In contrast, when the differential pair 30 passes by the pair of differential signaling vias 12 in parallel, because the electromagnetic field is coupled between the differential signaling vias 12, the crosstalk in the differential pair 30 passing in parallel is relatively low.

In the fifth embodiment, the pair of differential signaling vias 12 within the signal via pair 23 are formed of a pair of vias 10 adjacent to each other along the N1-N2 axis among the plurality of vias 10 disposed in a grid pattern at a given pitch. However, the pair of differential signaling vias 12 may be formed of a pair of vias 10 adjacent to each other along the M1-M2 axis or along the X1-X2 axis.

In the embodiments as described above, examples of specific numerical values were given, but the present disclosure is not limited thereto.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A multilayered wiring substrate that includes at least one signal layer and at least one ground layer, the multilayered wiring substrate comprising:
a first signal via extending in a direction substantially perpendicular to the layers of the multilayered wiring substrate, the first signal via being conductively connected to one of a pair of differential signaling wires provided in the signal layer, and formed on a first grid point; and
a second signal via extending in a direction substantially perpendicular to the layers of the multilayered wiring substrate, the second signal via being conductively connected to the other of the pair of differential signaling wires and formed on a second grid point that is positioned diagonally adjacent with respect to the first signal via.

2. The multilayered wiring substrate of claim 1, further comprising:
differential signaling wires aligned to pass between the first signal via and the second signal via.

3. A multilayered wiring substrate that includes at least one signal layer and at least one ground layer, the multilayered wiring substrate comprising:
a first signal via extending in a direction substantially perpendicular to the layers of the multilayered wiring substrate and conductively connected to one of a pair of differential signaling wires provided in the signal layer; and
a second signal via extending in a direction substantially perpendicular to the layers of the multilayered wiring substrate and conductively connected to the other of the pair of differential signaling wires,
wherein the first signal via and the second signal via are disposed, while being spaced apart from each other, so that a distance between a central point of the first signal via and a central point of the second signal via is longer than the shortest distance between central points of the signal vias that are conductively connected to the differential signaling wires in the signal layer.

4. The multilayered wiring substrate of claim 3, wherein the first signal via and the second signal via are disposed, while being spaced apart from each other, within a range in which the distance between the central point of the first signal via and the central point of the second signal via is shorter than two times of the shortest distance between central points of the signal vias that are connected to the differential signaling wires in the signal layer.

5. An electronic apparatus, comprising:
a multilayered wiring substrate provided with at least one signal layer and at least one ground layer, the multilayered wiring substrate including:
a first signal via extending in a direction substantially perpendicular to the layers of the multilayered wiring substrate, the first signal via being conductively connected to one of a pair of differential signaling wires provided in the signal layer and formed on a first grid point; and
a second signal via extending in a direction substantially perpendicular to the layers of the multilayered wiring substrate, the second signal via being conductively connected to the other of the pair of differential signaling wires and formed on a second grid point that is positioned diagonally adjacent with respect to the first signal via; and
a semiconductor component configured to be mounted on the multilayered wiring substrate.

6. A multilayered wiring substrate that includes at least one signal layer and at least one ground layer, the multilayered wiring substrate comprising:
a first signal via extending in a direction substantially perpendicular to the layers of the multilayered wiring substrate and conductively connected to the signal layer;
a second signal via extending in a direction substantially perpendicular to the layers of the multilayered wiring substrate, the second signal via being formed at a position adjacent to the first signal via, and conductively connected to the signal layer;
a first ground via extending in a direction substantially perpendicular to the layers of the multilayered wiring substrate, the first ground via being formed at a position adjacent to the first signal via, and conductively connected to the ground layer;
a second ground via extending in a direction substantially perpendicular to the layers of the multilayered wiring substrate, the second ground via being formed at a position adjacent to the second signal via, and conductively connected to the ground layer; and
a differential signaling pair aligned to pass between the first signal via and the first ground via or between the second signal via and the second ground via.

7. The multilayered wiring substrate of claim 6, wherein the differential signaling pair are aligned substantially in parallel to a line along which the first signal via and the second signal via are arranged.

8. A multilayered wiring substrate that includes at least one signal layer and at least one ground layer, the multilayered wiring substrate comprising:
a first signal via extending in a direction substantially perpendicular to the layers of the multilayered wiring substrate and conductively connected to the signal layer;
a second signal via extending in a direction substantially perpendicular to the layers of the multilayered wiring substrate, the second signal via being formed at a position adjacent to the first signal via, and conductively connected to the signal layer;
a first ground via extending in a direction substantially perpendicular to the layers of the multilayered wiring substrate, the first ground via being formed at a position adjacent to the first signal via, and conductively connected to the ground layer;
a second ground via extending in a direction substantially perpendicular to the layers of the multilayered wiring substrate, the second ground via being formed at a position adjacent to the second signal via, and conductively connected to the ground layer; and
a differential signaling pair aligned substantially in parallel to a line along which the first signal via and the second signal via are arranged.

9. An electronic apparatus, comprising:
a multilayered wiring substrate provided with at least one signal layer and at least one ground layer, the multilayered wiring substrate including:
a first signal via extending in a direction substantially perpendicular to the layers of the multilayered wiring substrate and conductively connected to one of a pair of differential signaling wires provided in the signal layer; and
a second signal via extending in a direction substantially perpendicular to the layers of the multilayered wiring substrate and conductively connected to the other of the pair of differential signaling wires,
wherein the first signal via and the second signal via are disposed while being spaced apart from each other so that a distance between a central point of the first signal via and a central point of the second signal via is longer than the shortest distance between central points of the signal vias that are conductively connected to the differential signaling wirings on the signal layer; and
a semiconductor component configured to be mounted on the multilayered wiring substrate.
